# FASCICULE DE BREVET EUROPEEN

(11) **EP 2 208 218 B1**
(45) Date de publication et mention de la délivrance du brevet: **16.03.2016**
(21) Numéro de dépôt: 08843182.0
(22) Date de dépôt: 06.10.2008
(51) Int. Cl.: H01J 37/32

(54) **PROCÉDÉ ET DISPOSITIF POUR LE TRAITEMENT PAR PLASMA DE SUBSTRATS AU DÉFILÉ**
VERFAHREN UND VORRICHTUNG ZUR PLASMA-BEHANDLUNG SUBSTRATE IM DURCHLAUF
METHOD AND DEVICE FOR PLASMA TREATMENT OF MOVING SUBSTRATES

(30) Priorité: 22.10.2007 EP 07119011
(43) Date de publication de la demande: 21.07.2010
(73) Titulaire: Advanced Galvanisation AG, 8212 Neuhausen (CH)
(72) Inventeur: VANDEN BRANDE, Pierre, CH-8224 Löhningen (CH)
(74) Mandataire: Callewaert, Koen
(86) Numéro de dépôt international: PCT/EP2008/063354
(87) Numéro de publication internationale: WO 2009/053235

(56) Documents cités:
- EP-A- 1 020 892
- WO-A-01/75930
- WO-A-02/12591
- WO-A-02/084699
- US-A1- 2002 023 899
- US-A1- 2003 159 782
- US-B1- 7 223 321

## Description

L'invention est relative à un procédé de traitement par plasma, notamment de nettoyage et/ou de chauffage en grande série, de substrats métalliques ou de substrats isolants, se présentant sous la forme de fils, de poutrelles, de tubes, de plaques, de profilés, de tous types de sections transversales, de bandes et/ou tôles, mais aussi de pièces disposées sur des supports, par exemple des crochets ou des paniers métalliques, transportés dans une zone de traitement à l'aide de dispositifs généralement quelconques, tels qu'un banc de rouleaux ou un système de transport par monorail.

Dans ce procédé, le substrat à traiter est déplacé suivant un sens déterminé dans une chambre à vide présentant une zone de traitement dans laquelle une décharge électrique est créée entre une électrode et un substrat, à proximité de la surface de ce dernier, au moyen d'un dispositif faisant aussi l'objet de l'invention.

Le procédé et le dispositif, suivant l'invention, permettent, en particulier, d'éliminer une couche de contamination du substrat, telle qu'un oxyde métallique superficiel et du carbone superficiel, de manière à favoriser l'adhésion d'un revêtement appliqué ultérieurement par une technique de dépôt sous vide.

L'invention permet également de chauffer efficacement le substrat et peut, par conséquent servir au recuit de produits métalliques ou assurer la formation de composés de surface par diffusion ou réaction avec le substrat lorsque des substances réactives sont apportées sous forme de gaz à une pression inférieure à 1000 mbar dans la zone de traitement. Le procédé, suivant l'invention, est applicable à tout substrat suffisamment conducteur électrique, donc applicable aussi bien aux substrats en acier doux, en inox, en aluminium, en cuivre qu'à d'autres métaux, mais aussi à des substrats conducteurs électriques revêtus d'une couche isolante électrique mince et, dans une forme de réalisation particulière de l'invention, à des substrats isolants, bien qu'il ait été essentiellement développé pour une application industrielle visant le prétraitement des aciers doux avant zingage par procédé de dépôt sous vide. C'est cette grande souplesse d'application qui confère à ce nouveau procédé un avantage considérable par rapport aux procédés de traitement utilisés jusqu'ici en particulier visant au traitement des produits en acier. En effet, comme cela sera explicité ci-dessous plus en détail, ce procédé permet, par exemple, de traiter les surfaces non seulement ouvertes mais aussi partiellement fermées de produits de toutes formes de sections du moment que le plasma généré par le nouveau dispositif puisse diffuser vers ces surfaces. Ce procédé de par son dispositif particulier d'excitation est bien moins sensible à la formation d'arcs électriques que les procédés de l'état antérieur de la technique qui sont basés sur un chauffage du plasma par génération d'électrons secondaires. Enfin, ce nouveau procédé permet aussi, par une excitation alternative ou pulsée d'une électrode faisant face au produit à traiter, un traitement des surfaces métalliques recouvertes de substances isolantes électriques, telles que des tôles, profilés ou poutrelles d'acier revêtus d'une peinture non conductrice du courant électrique, par exemple.

### Etat de l'art antérieur

Les procédés connus jusqu'ici pour le nettoyage ou le chauffage d'un produit métallique par plasma présentent plusieurs désavantages :
- Ils ne permettent que de traiter des surfaces métalliques, tout au plus recouvertes d'une couche d'oxyde métallique de quelques nanomètres d'épaisseur, et ne permettent donc pas le nettoyage de produits très fortement oxydés ou revêtus de polymères ;
- Ces procédés connus de l'état de l'art antérieur, basés exclusivement sur la génération d'un plasma par émission d'électrons secondaires, sont extrêmement propices à la formation d'arcs électriques qui peuvent rendre la décontamination du substrat très difficile, voire impossible, et même conduire à une dégradation irrémédiable de la surface de ce dernier par formation de points de fusion superficielle par dissipation de l'énergie des arcs produits.
- L'art antérieur de la technique ne permet que le traitement de substrats métalliques de formes géométriques simples, essentiellement des substrats longitudinaux à surfaces fortement ouvertes traversant de part en part les dispositifs de traitement. Selon l'état de la technique, antérieur à l'invention décrite dans WO 02/12591, il n'était par exemple pas possible de traiter, en une seule opération, toutes les faces extérieures d'un produit métallique, rendant impossible le traitement de poutrelles, de tubes et de profilés, par exemple, mais compliquant aussi lourdement le traitement de tôles à cause des variations de largeur de bandes et des déplacements latéraux inévitables de ces dernières dans une ligne de défilement en continu propre à l'industrie métallurgique et en particulier pour le traitement de tôles d'acier. En effet, les procédés existants impliquaient la création, à la surface du substrat, d'une décharge magnétron en disposant à l'arrière de la surface à traiter des réseaux d'aimants. Ceci limitait évidemment cette technologie au traitement de tôles et de bandes relativement minces pour obtenir un champ magnétique suffisamment intense pour permettre la formation d'un plasma par décharge magnétron au voisinage de la surface opposée à celle derrière laquelle les réseaux d'aimants étaient disposés. Ceci est particulièrement le cas pour des tôles en acier doux qui doivent en outre être saturées par le champ d'induction magnétique. Le dispositif décrit dans WO 02/12591, faisant usage d'au moins un miroir magnétique que doit traverser un produit longitudinal, résout cette difficulté mais présente encore des inconvénients majeurs pour bon nombre d'applications pratiques. En effet, si ce dispositif permet le traitement de produits allongés de toutes formes tels que des poutrelles de pratiquement toutes sections, des profilés, des tôles minces ou épaisses, des tubes, des fils etc., dans la pratique il présente encore certains inconvénients pour le traitement des extrémités des produits longs qui ne traversent donc pas de part en part le dispositif de traitement. Dans ce cas, la zone de décharge magnétron à la surface du produit à traiter, limitée à la longueur du substrat dans la zone de traitement, peut s'avérer insuffisante pour former un plasma stable du fait d'un confinement axial du plasma insuffisant en direction du miroir magnétique qui n'est pas traversé par le produit. Pour pallier à ce problème, un moyen simple consiste, lors du traitement des extrémités, à augmenter la puissance électrique utile pour maintenir la densité du plasma par augmentation du taux d'ionisation, afin de compenser les pertes de plasma par diffusion ambipolaire axiale en direction du miroir non traversé par le produit. Ceci complique, toutefois, fortement la gestion du système. Un autre inconvénient de ce dispositif est qu'il ne permet que difficilement le traitement de produits présentant des surfaces intérieures fortement fermées. Ainsi, par exemple, ce dispositif permet le traitement de toute la surface de poutrelles en U, en T, ou en I, mais plus difficilement le traitement de la surface intérieure d'un U partiellement refermé ou d'un tuyau fendu suivant son axe. Un autre inconvénient de ce dispositif est relatif au fait que les caractéristiques électriques du plasma dépendent essentiellement des caractéristiques géométriques et de surface du substrat pouvant créer des instabilités lors du traitement en parallèle de plusieurs substrats, comme par exemple des poutrelles défilant en parallèle dans la zone de traitement. Dans ce cas, la décharge est susceptible de ne pas se former sur tous les substrats placés parallèlement dans la zone de traitement car le plasma se forme préférentiellement dans les zones de moindre impédance et certains produits pourraient ne pas être traités. Un autre inconvénient survient aussi lorsqu'un substrat est recouvert sur certaines zones d'un matériau isolant électrique empêchant la symétrie axiale nécessaire au fonctionnement de la décharge magnétron décrite dans WO 02/12591, et le traitement de la pièce est alors impossible. Un inconvénient fréquent en pratique des dispositifs et procédés connus jusqu'ici, se présente lorsque le substrat est fortement contaminé par un oxyde métallique. Dans ce cas, l'impossibilité de contrôler indépendamment le flux d'ions vers le substrat et la tension de décharge favorise la formation d'arcs électrique, ce qui limite fortement la densité de puissance utile pouvant conduire à l'impossibilité de décontaminer un substrat sans risque d'endommager sa surface par spots d'arcs.

### Description générale de l'invention

Le procédé et le dispositif, suivant l'invention, proposés visent à résoudre ces inconvénients par les moyens suivants :
- Le chauffage du plasma n'est plus subordonné à l'émission d'électrons secondaires mais est fondamentalement ohmique et stochastique par couplage inductif radiofréquence (RF) d'énergie électromagnétique, ce qui rend possible le traitement de substrats très fortement contaminés, voire recouvert en surface par des matériaux isolants électriques, et de formes variées. Il est, par exemple, possible de traiter les extrémités de substrats longs, des substrats non nécessairement allongés ou les surfaces intérieures de substrats fortement fermés.
- Dans la forme de réalisation principale de l'invention, le système contre-électrode / substrat, qui n'intervient plus dans la création du plasma, permet un contrôle indépendant de la différence de potentiel d'accélération des ions vers le substrat et de leur flux au substrat. En effet, le flux d'ions ne dépend que de la densité de plasma et est directement proportionnel à la puissance RF couplée dans la décharge.

Le couplage inductif RF est un moyen relativement simple, et par ailleurs connu, permettant de créer un plasma de haute densité à puissance donnée, par comparaison à un couplage capacitif pour lequel la plus grande partie de la puissance RF est utilisée dans l'accélération des ions dans les gaines. Le couplage inductif RF est généralement appliqué au moyen d'un solénoïde inducteur placé à l'extérieur d'une enceinte à vide constituée en matériau diélectrique (céramique, verre, ou quartz) pour permettre la transmission de l'énergie électromagnétique. Dans les installations de traitement industriel du type de celles visées par l'invention, qui sont relatives au traitement de poutres et de tôles d'acier, par exemple, la taille des enceintes à vide est telle que les forces qui seraient engendrées par la pression atmosphérique extérieure rendraient extrêmement complexe, voire hasardeuse, la construction d'une partie de l'enceinte à vide de cette taille, en matériaux diélectriques. En effet, pour des dimensions dépassant le mètre, des constructions mécano-soudées, en acier ou en aluminium, munies de raidisseurs sont inévitables. Cette contrainte mécanique impose de placer l'inducteur à l'intérieur de l'enceinte à vide, ce qui implique des difficultés de nature électrique pour lesquelles l'invention apporte des solutions.

Le traitement de décontamination de pièces métalliques, suite au bombardement ionique des surfaces de ces dernières, produit une forte émission en atomes provenant de la couche de contamination éliminée, dont il faut nécessairement protéger l'inducteur, qui doit conserver une résistance superficielle la plus faible possible, afin d'y minimiser les pertes par effet Joule. L'inducteur est, par exemple, formé par un solénoïde. En général, l'inducteur est en cuivre et est avantageusement revêtu sur sa surface par un dépôt d'argent afin de réduire au maximum sa résistance superficielle puisque le courant RF circule essentiellement à la surface de l'inducteur.

La protection de la surface de couplage de l'inducteur de toute contamination par la matière émise par la surface décontaminée, comme par exemple du fer, est assurée, suivant l'invention, au moyen d'un écran de Faraday disposé en son voisinage et de forme semblable à celle de l'inducteur, dont la conception permet non seulement la protection totale de cette face active de l'inducteur, mais aussi une transmission optimale de la puissance électromagnétique RF dans la zone de traitement.

Dans une configuration particulièrement avantageuse, l'écran de Faraday est formé par une structure métallique disposée à l'intérieur d'un solénoïde inducteur, et présente une série de fentes parallèles entre-elles et perpendiculaires à la direction de circulation du courant inducteur parcourant le solénoïde. Chaque fente est protégée par un longeron métallique solidaire de l'écran de Faraday et placé du côté de la zone de traitement au droit de la fente à une petite distance de cette dernière pour ne pas court-circuiter la capacité électrique crée par la fente. Un longeron se situe donc en face de chaque fente de l'écran de Faraday, de manière à empêcher la contamination d'atteindre la surface du solénoïde par ces fentes.

L'écran de Faraday et les longerons protecteurs des fentes longitudinales sont assemblés au moyen de deux brides situées de préférence en dehors de la zone d'influence de l'inducteur. Les brides sont avantageusement refroidies à l'eau. Ces brides doivent préférablement être en dehors de la zone d'influence du solénoïde inducteur et le sont effectivement lorsque l'écran de Faraday présente une longueur suffisamment importante pour qu'elles soient situées à l'extérieur du solénoïde et suffisamment éloignées des extrémités de ce dernier pour ne pas être le siège de courants induits. On peut avantageusement coupler à cette mesure, généralement une, et parfois plusieurs, sections isolantes dans les brides supports de l'écran de Faraday, de manière à ce que ces dernières ne constituent pas un circuit électrique fermé, ce qui réduit d'autant plus la valeur du courant induit dans l'écran de Faraday.

Seules des simulations permettent de déterminer l'agencement optimal des fentes longitudinales de la position des brides par rapport à l'inducteur et le nombre de sections isolantes à prévoir par bride. L'agencement optimal est celui qui conduit à une transmission maximale de la puissance électromagnétique rayonnée par l'inducteur au travers de l'écran de Faraday.

L'écran de Faraday est, selon l'invention, polarisé électriquement, positivement en moyenne dans le temps par rapport au substrat ou à une électrode lui faisant face, pour constituer une électrode dirigée vers le substrat ou vers les substrats à traiter et permettre le couplage de la puissance nécessaire à leur traitement.

Cette électrode constitue, par conséquent, suivant l'invention, l'écran de Faraday susdit et permet d'accumuler à sa surface, sans altération des conditions de traitement des substrats, la couche de contamination éliminée des substrats traités.

Dans le dispositif suivant l'invention, l'écran de Faraday constitue, par conséquent, une électrode conductrice adjacente au plasma, en particulier en contact avec le plasma, qui est polarisée en moyenne positivement par rapport à une contre-électrode ou par rapport au substrat à traiter. L'écran de Faraday, qui forme donc principalement une anode, a pour but de récupérer les électrons du plasma et ferme ainsi un circuit électrique sur le plasma qui est créé par un autre moyen. Cet autre moyen est, de préférence, une excitation électromagnétique inductive en radio fréquence au travers de l'écran de Faraday. Ce dernier permet ainsi d'accélérer les ions présents dans le plasma vers une contre-électrode qui est, par exemple, formé par le substrat à traiter.

Le plasma est généré dans l'espace intercalaire entre deux électrodes, soit entre l'écran de Faraday et les substrats dans la zone de traitement, soit entre l'écran de Faraday et une contre-électrode.

Il est crucial d'éviter la formation de tout plasma parasite entre l'électrode, formant l'écran de Faraday, et l'inducteur. A cette fin, il faut limiter les espaces libres entre cette électrode et l'inducteur à des dimensions inférieures à l'épaisseur de la gaine qui pourrait se former entre ces surfaces et un plasma éventuel. L'épaisseur de cette gaine est typiquement inférieure à, ou de l'ordre de, 1 mm.

Par ailleurs, il est aussi nécessaire, afin d'augmenter la valeur de la réactance capacitive entre l'inducteur et l'électrode formant l'écran de Faraday, pour limiter le couplage capacitif, mais aussi pour des raisons de construction, de maintenir une séparation d'au moins plusieurs millimètres entre ces surfaces. A cet effet, généralement une distance 1 à 10 cm doit être maintenue entre l'écran de Faraday et l'inducteur.

Afin de respecter ces deux conditions, l'invention prévoit le placement d'un matériau diélectrique intercalaire dans l'espace séparant l'inducteur de l'électrode formant l'écran de Faraday. Lorsque l'inducteur et l'électrode sont convenablement refroidis, par exemple par circulation d'eau dans un circuit de refroidissement prévu à cet effet, un matériau intercalaire en polymère, tel du téflon, peut être utilisé, sinon on peut avantageusement faire usage, d'une mousse céramique, ou encore d'une laine de verre ou d'alumine, comme matériau intercalaire. En effet, ces dernières ont l'avantage de résister à la température et de limiter les espaces libres ou pourraient se former le plasma par la proximité des fibres voisines.

Malheureusement, en augmentant l'espace entre l'inducteur et l'électrode formant l'écran de Faraday, où est placé le diélectrique intercalaire, bien que l'on augmente la réactance capacitive de couplage entre ces deux électrodes, on ne diminue pas suffisamment, par ce seul moyen, le courant de déplacement RF vers l'écran de Faraday. En effet, en augmentant cet espace on éloigne aussi le courant inducteur du courant induit dans le plasma, ce qui, par augmentation de la réactance inductive, augmente l'amplitude de la tension RF qui va dans le sens d'une augmentation du courant capacitif RF parasite que l'on cherche à diminuer dans l'écran de Faraday.

Le courant parasite RF est bloqué en plaçant un filtre passe-bas entre l'électrode formant l'écran de Faraday et l'alimentation électrique qui y est connectée. Pratiquement un filtre ne permettant que le passage de fréquences inférieures à 1MHz et de préférence inférieures à 100kHz est approprié car il permet une excitation alternative ou pulsée de l'écran de Faraday, tout en bloquant tout courant RF vers le générateur connecté à l'écran de Faraday, alors que le signal de plus faible fréquence du générateur connecté à l'écran de Faraday vers le générateur RF connecté à l'inducteur est bloqué par l'importante réactance capacitive créée par l'espace entre le solénoïde inducteur et l'électrode formant l'écran de Faraday. Le filtre passe-bas est généralement constitué d'une self placée en série entre l'écran de Faraday et son générateur, et d'un condensateur reliant une des extrémités de la self à la masse, mais d'autres configurations équivalentes sont aussi possibles.

Le dispositif, suivant l'invention, se distingue donc de l'art antérieur par la présence d'un espace intercalaire suffisant pour bloquer un signal de fréquence égale ou inférieure à la haute fréquence vers l'inducteur couplé à l'usage d'un filtre passe-bas destiné à bloquer le signal RF, et situé entre l'écran de Faraday et son alimentation. Dans cet espace ne peut se former un plasma du fait de la présence d'un matériau diélectrique intercalaire.

Un blindage à la masse peut être avantageusement prévu pour protéger l'ensemble du dispositif de traitement, permettre sa fixation mécanique dans la chambre à vide, assurer la fixation d'élingues pour sa manipulation lors des entretiens de nettoyage nécessaires après chaque campagne de production, mais aussi réduire l'émission RF dans la chambre à vide. Dans ce cas, des précautions doivent être prises pour éviter la formation de tout plasma parasite entre ce blindage, l'inducteur, d'une part, et l'électrode formant l'écran de Faraday, d'autre part, mais aussi les pertes en courant de déplacement par couplage capacitif RF vers la masse. Les courants parasites sont réduits en maintenant un espace suffisant, d'au moins plusieurs millimètres, entre la surface intérieure de ce blindage et la surface extérieure du solénoïde inducteur et, éventuellement, avec les brides de l'écran de Faraday.

Pour éviter la formation de tout plasma parasite, il faut combler l'espace entre le blindage et l'inducteur et l'écran de Faraday avec un matériau diélectrique intercalaire tel qu'un polymère, une céramique, ou du verre, soit sous forme de matériau massif, d'une mousse, ou d'un matériau fibreux. Des textiles en fibre de verre peuvent aussi être utilisés, bien entendu. Les matériaux doivent être compatibles avec les gammes de température envisagées et ne pas dégazer excessivement en cours d'utilisation pour ne pas contaminer le substrat lors du traitement.

### Description des figures

La figure 1 est une représentation schématique en perspective d'une forme de réalisation particulière du dispositif suivant l'invention.
La figure 2 représente une vue éclatée des différents éléments constitutifs du dispositif représenté à la figure 1.
La figure 3 est une vue en perspective de l'électrode formant un écran de Faraday de la forme de réalisation de l'invention représentée aux figures1 et 2.
La figure 4 est une représentation schématique d'une autre forme de réalisation du dispositif, suivant l'invention.
La figure 5 représente une vue éclatée d'une forme de réalisation intéressante du dispositif selon l'invention pour la mise en oeuvre d'une source plasma.
La figure 6 représente une vue éclatée d'une forme de réalisation intéressante du dispositif selon l'invention pour la mise en oeuvre d'une source à ions.
La figure 7 représente la source plasma ou la source à ions, selon l'invention, lorsque celle-ci est assemblée.

Dans les différentes figures, les mêmes chiffres de référence se rapportent à des éléments analogues ou identiques.

### Description détaillée de l'invention

### 1. Le dispositif suivant l'invention :

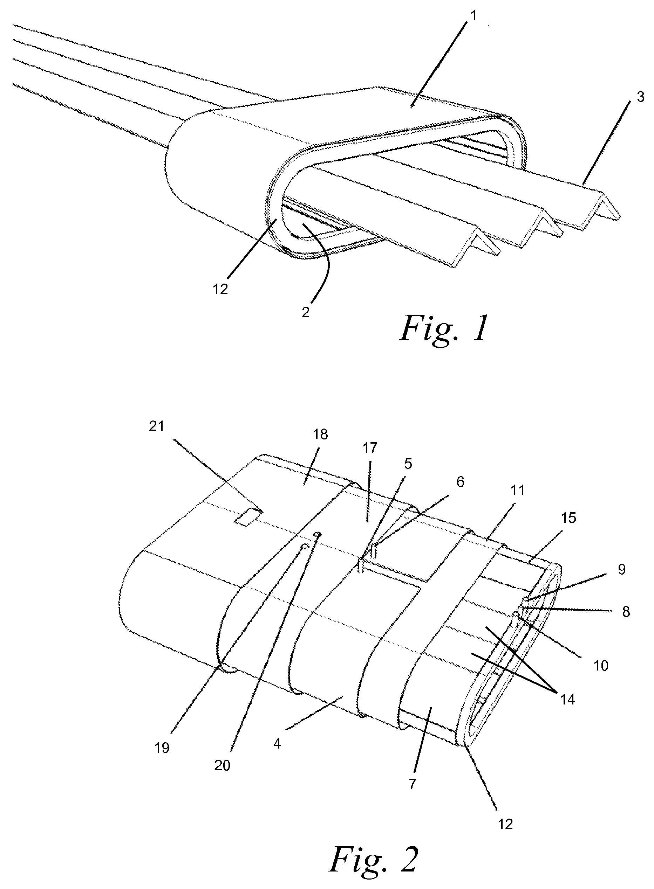

Un dispositif suivant une forme de réalisation particulièrement intéressante de l'invention est représenté schématiquement aux figures 1 à 3. Ce dispositif 1 est monté dans une chambre à vide et comprend une zone de traitement 2 dans laquelle peut défiler un ou plusieurs substrats métalliques d'une manière sensiblement continue. Cette zone de traitement 2 se situe à l'intérieur du dispositif

Dans la figure 1 un dispositif est représenté à travers lequel trois poutrelles métalliques 3 se déplacent, parallèlement l'une à l'autre, suivant leur direction longitudinale. Les poutrelles 3 sont supportées par des bancs de rouleaux, qui ne sont pas représentés aux figures, en amont et en aval du dispositif de traitement.

Le dispositif présente des moyens pour la génération d'un plasma dans la zone de traitement 2. Ces moyens comprennent entre-autres un inducteur 4 couplé à un générateur radio-fréquence afin de permettre de générer par couplage inductif radio-fréquence un plasma dans la zone de traitement 2. L'inducteur 4, qui entoure au moins partiellement la zone de traitement 2, est avantageusement constitué par un solénoïde comprenant une spire. Cet inducteur 4 est connecté au générateur radiofréquence (non-représenté) par des connecteurs 5 et 6 prévus à cet effet, via un circuit d'adaptation d'impédance, également non représenté. Un des connecteurs 5 ou 6 peut être connecté au générateur radio-fréquence et l'autre des connecteurs 5 ou 6 est alors connecté à la masse. Il est clair que d'autres configurations équivalentes, telle qu'une configuration push-pull, réduisant l'amplitude de tension radio-fréquence par un facteur deux par rapport à la masse, sont également possibles.

Une électrode formant un écran de Faraday 7 est prévue entre l'inducteur 4 et la zone de traitement 2 où se forme le plasma et permet de protéger l'inducteur de toute contamination par la matière émise par la surface des substrats. Cette électrode 7 est alimentée en puissance électrique DC, qui peut éventuellement être pulsée, ou en puissance électrique haute fréquence (HF) avec une fréquence inférieure à 1 MHz, en fonction de l'application visée. L'électrode 7 présente un connecteur 8 pour être alimenté en puissance DC ou HF.

Afin de pouvoir refroidir l'électrode 7 celle-ci présente un circuit de circulation d'eau qui est alimenté par un connecteur 9 et déchargé par un connecteur 10.

L'inducteur 4 et l'écran de Faraday 7 présentent la forme d'un manchon enveloppant la zone de traitement 2. L'axe longitudinal de ce manchon correspond sensiblement à la direction de défilement des substrats. Le manchon présente une ouverture d'entrée et une ouverture de sortie à travers lesquelles le substrat peut entrer la zone de traitement 2 et sortir de celle-ci.

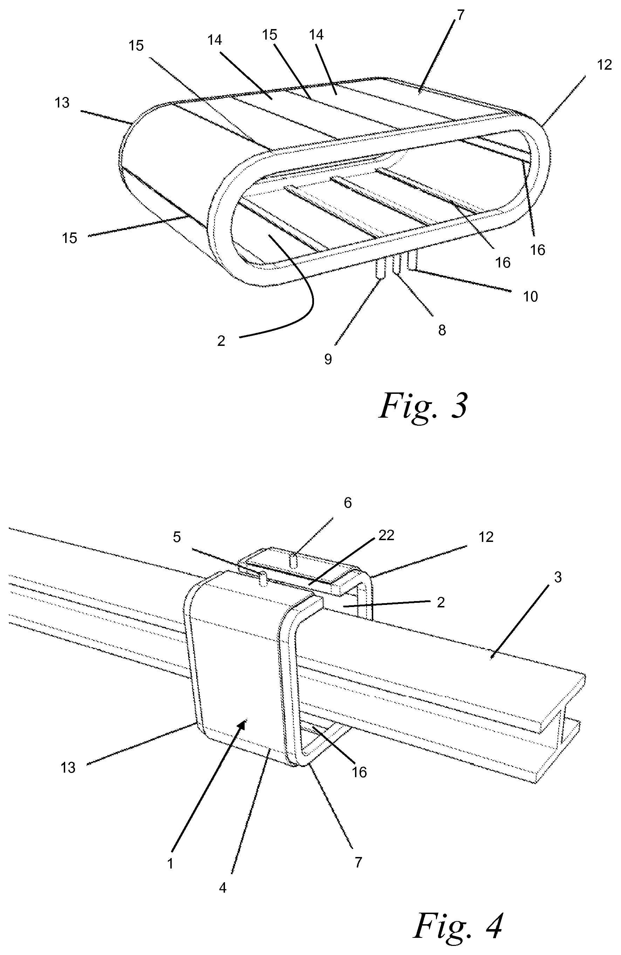

Comme représenté à la figure 3, l'électrode formant l'écran de Faraday 7 est constituée d'une partie centrale située entre deux brides 12 et 13. Ces brides 12 et 13 sont réalisées en un matériau conducteur d'électricité et sont de forme annulaire. La partie centrale comprend une succession de lamelles 14 qui sont liées avec leurs extrémités opposées respectivement aux brides 12 et 13. Entre les lamelles 14 des fentes 15 sont présentes. Ces fentes 15 s'étendent de préférence parallèlement à la direction de défilement des substrats ou, en d'autres mots, sensiblement parallèlement à l'axe du solénoïde qui constitue l'inducteur 4. Ainsi, ces fentes 15 sont sensiblement perpendiculaires à la direction de circulation du courant inducteur dans l'inducteur 4.

Les fentes 15 sont protégées par des longerons 16 placés à l'intérieur de l'électrode formant l'écran de Faraday 7, dans la zone de traitement 2, et supportés par les brides 12 et 13 de cette électrode 7. Une petite distance est maintenue entre les longerons 16 et les lamelles 14 de manière à ne pas court-circuiter les fentes 15 et afin de permettre que le champ électromagnétique généré par l'inducteur 4 s'étende jusqu'à la zone de traitement 2. L'une des brides 12 est munie des connecteurs susdits 9 et 10 pour son circuit de refroidissement à l'eau et du connecteur 8 pour la polarisation électrique de l'électrode 7 par rapport au substrat 3 au moyen d'une alimentation en puissance électrique DC ou HF.

Il est clair que l'électrode formant l'écran de Faraday 7 n'est pas nécessairement constituée d'une succession de lamelles, mais peut également comprendre une tôle métallique pourvue d'une succession d'ouvertures en forme de fentes.

Dans une variante de la forme de réalisation du dispositif décrit ci-dessus, les brides 12 et 13 peuvent présenter au moins une découpe de manière à ne pas former un circuit fermé et contribuer à la réduction de l'amplitude des courants qui y sont éventuellement induits par l'inducteur 4.

De préférence, l'électrode formant un écran de Faraday 7 est recouverte d'un matériau diélectrique 11 avant d'être introduite à l'intérieur de l'inducteur 4.

L'inducteur 4 est protégé par un matériau diélectrique intercalaire 17 avant d'être recouvert par un blindage 18. Ce dernier est généralement connecté électriquement à la masse. Ce blindage 18 présente des ouvertures 19, 20 et 21 qui permettent le passage des connecteurs 5 et 6. Le blindage 18 peut aussi, dans certains cas, être maintenu à un potentiel flottant en l'isolant de la masse par ses points de fixation dans la chambre à vide.

La figure 4 est une représentation schématique d'une configuration particulière du dispositif suivant l'invention. Cette configuration permet le traitement de produits longs de fort tonnage tels que des poutres 3 présentant une section en I. La section transversale du dispositif 1 est adaptée à la section transversale du produit 3. Dans cette configuration le dispositif de traitement 1 comprend l'inducteur 4 et une électrode formant l'écran de Faraday 7 dont les brides 12 et 13 ressortent de l'inducteur 4 pour ne pas être le siège de courants électriques induits. Le matériau diélectrique intercalaire 17 et le blindage 18 ne sont pas représentés pour mettre l'accent sur la partie active du dispositif. Le matériau diélectrique intercalaire 11 n'est pas visible car celui-ci est situé entre l'inducteur 4 et l'électrode 7. L'inducteur 4 est alimenté en puissance RF par des connecteurs 5 et 6. Une ouverture 22 est laissée dans la partie supérieure du dispositif de traitement 1, qui permet éventuellement de transporter le produit à traiter au moyen d'un support suspendu sous un monorail non représenté. Ce monorail se déplace en dehors de la zone de traitement 2.

On peut aussi imaginer une situation où l'ouverture 22 serait dans la partie inférieure du dispositif 1. De cette manière l'on permet le transport des substrats à travers la zone de traitement 2 sur des chariots circulant sur un ou plusieurs rails. Une ouverture orientée 22 vers le bas permet aussi la récupération des débris qui se détachent de la couche de contamination qui s'accumule sur l'électrode formant l'écran de Faraday 7 dans un bac de récupération non représenté.

Il est utile de souligner que l'inducteur, qui peut être dans une de ses formes particulièrement avantageuse constitué par un solénoïde comprenant une ou plusieurs spires, peut présenter une géométrie généralement quelconque. En effet, les champs électromagnétiques induits par l'inducteur étant confinés à la périphérie du plasma et au voisinage de l'électrode formant l'écran de Faraday protégeant l'inducteur, la valeur du champ électromagnétique est sensiblement indépendante de la géométrie générale du dispositif et de la proximité éventuelle d'autres dispositifs indépendants. Ceci peut être mis à profit dans des applications particulières. Par exemple, pour le traitement d'une face particulière d'un substrat on pourrait prévoir un inducteur et une électrode formant un écran de Faraday dont la surface de forme semblable soit sensiblement parallèle à cette face et devant lequel le produit défilerait.

On peut ainsi, par exemple, traiter indépendamment par cette méthode les deux faces d'une tôle d'acier défilant devant un dispositif plan constitué d'un inducteur plan protégé par son électrode formant un écran de Faraday opposé à la face à traiter. Cette configuration permettrait, en retournant la tôle horizontalement à 180°, de traiter les deux faces de la tôle avec des dispositifs situés sous la tôle, et dont les électrodes formant l'écran de Faraday pourraient servir de bacs de récupération de la couche de contamination.

Un autre avantage de cette conception modulaire du dispositif est de pouvoir limiter la réactance de l'inducteur en limitant la longueur parcourue par le courant, mais aussi de diviser la puissance radiofréquence sur plusieurs inducteurs lors du traitement de produits de grandes dimensions. S'il faut, par exemple, traiter la carrosserie complète d'une automobile, il est possible de concevoir un système faisant usage de quatre dispositifs dont deux dispositifs ont une largeur de 2 mètres pour le traitement des faces supérieures et inférieures de la carrosserie et dont deux dispositifs présentent une largeur de 1,5 mètre pour le traitement des côtés latéraux de la carrosserie. Cette conception modulaire permet aussi d'adapter la géométrie des dispositifs au traitement des surfaces intérieures de certains produits, ou de déplacer latéralement, et donc perpendiculairement à la direction de déplacement des substrats traités, les dispositifs pour s'adapter aux dimensions transversales particulières de différents substrats.

### 2. Conditions opérationnelles et configurations particulières de l'invention

### 2.1. Nature et pression des gaz de traitement

Pour le nettoyage de produits métalliques, en particulier les aciers sous formes de produits longs et de produits plats, la pression du gaz présent dans la chambre à vide est fixée entre 0,05 Pa et 5 Pa (5 10⁻⁴ mbar et 5 10⁻² mbar).

Ce gaz est le plus fréquemment composé de 100% d'argon. Dans des applications spécifiques, l'argon peut être combiné à de l'oxygène, à de l'hydrogène, ou éventuellement à d'autres gaz rares comme, par exemple, He, Kr ou Xe.

Lorsque le dispositif, suivant l'invention, est utilisé pour le chauffage de produits avec, éventuellement, traitement de diffusion d'un élément amené sous forme d'une molécule gazeuse le contenant, le gaz de traitement est en général de l'argon, éventuellement mélangé avec des gaz contenant les éléments à faire diffuser à la surface du produit traité dans le cas d'un traitement réactif avec la surface du substrat. Un tel gaz pourrait par exemple comprendre des gaz hydrocarbonés pour la diffusion de carbone à la surface du produit, ou des gaz organométalliques pour l'apport de métaux à cette surface. La pression totale du gaz doit en général être supérieure à 5 Pa pour éviter l'érosion par pulvérisation de la surface du substrat et est, de préférence, comprise entre 5 Pa et 100 Pa (entre 0,05 mbar et 1 mbar).

### 2.2. Excitation radiofréquence de l'inducteur

L'inducteur 4 est d'une manière avantageuse excité avec une fréquence d'excitation comprise entre 1 MHz et 170MHz et de préférence entre 1 et 30MHz, en particulier 13.56MHz, en fonction de la longueur parcourue par le courant dans l'inducteur. Les fréquences les plus basses sont choisies pour des dispositifs de grandes sections afin de réduire l'impédance de la self de l'inducteur. Pour cette même raison, l'inducteur ne comporte le plus souvent qu'une spire unique, ce qui permet aussi de construire des dispositifs présentant une ouverture comme décrite ci-dessus et représentée, par exemple, à la figure 4. Ainsi, ceci permet l'usage de dispositifs de transport suspendus sur monorail, sur chariots, et/ou l'élimination de la couche de contamination qui se détacherait éventuellement de l'électrode formant l'écran de Faraday dans un bac de récupération placé sous le dispositif de traitement.

Préférentiellement la fréquence classique de 13.56 MHz est utilisée, mais des fréquences inférieures à 10 MHz et en particulier entre 2 MHz et 5 MHz, sont intéressantes pour les installations dont la longueur parcourue par le courant dans l'inducteur dépasse 3 mètre. La puissance radiofréquence utile par dispositif varie en fonction de la taille du dispositif mais sera en général supérieure ou égale à 5 kW. Typiquement, cette puissance est située entre 5kW et 30 kW par inducteur bien que des puissances inférieures ou supérieures soient envisageables.

### 2.3. Excitation de l'électrode formant l'écran de Faraday

L'électrode, qui forme l'écran de Faraday, est polarisée positivement par rapport au substrat traité ou une contre-électrode située entre l'écran de Faraday et le substrat. Ce substrat ou cette contre-électrode est généralement, mais pas toujours, connecté à la masse de l'installation. La tension moyenne sur un cycle de polarisation, par rapport au potentiel du substrat traité ou de la contre-électrode, doit être positive, c'est-à-dire le rapport de l'intégrale de la tension sur une période à la période est positif. La polarisation peut donc être continue, alternative redressée, ou alternative polarisée positivement par rapport au substrat ou la contre-électrode avec des impulsions négatives éventuelles.

La fréquence d'excitation de l'électrode formant l'écran de Faraday doit être inférieure d'au moins un facteur 10 par rapport à la fréquence radiofréquence couplée à l'inducteur. En pratique cette fréquence d'excitation est inférieure à 1 MHz et de préférence inférieure à 100 kHz. En cas d'un courant continu (DC), cette fréquence d'excitation est, en particulier, nulle avec éventuellement des impulsions négatives.

Une alimentation électrique est connectée entre l'électrode formant l'écran de Faraday et le substrat ou une électrode lui faisant face. Cette alimentation est régulée en puissance proportionnellement à l'aire des substrats faisant face à l'électrode formant l'écran de Faraday et se déplaçant devant cette électrode à travers la zone de traitement.

Il est utile de mentionner que la puissance appliquée sur l'électrode formant l'écran de Faraday est de préférence au moins égale à la puissance radiofréquence appliquée sur l'inducteur pour permettre la création du plasma. Cette puissance appliquée sur l'électrode est avantageusement supérieure à la valeur de la puissance radiofréquence appliquée. En fait, le procédé est d'autant plus économique que le rapport de la puissance de l'électrode formant l'écran de Faraday à la puissance radiofréquence couplée par l'inducteur est important. Ce point est important pour les applications métallurgiques visées où les puissances impliquées sont considérables et les coûts d'investissement et d'utilisation des alimentations RF beaucoup plus élevés que ceux des alimentations fonctionnant à des fréquences inférieures 100 kHz.

### 2.4. Conditions à respecter par le substrat traversant le dispositif de traitement

Le substrat métallique qui traverse le dispositif de traitement doit avoir des dimensions transversales limitées pour ne pas être le siège de courants induits. Pour se faire, le substrat ne doit en aucun cas être en contact et être suffisamment éloigné de la zone périphérique du plasma constituant le siège des courants induits par l'inducteur. Cette zone périphérique du plasma, qui est généralement de l'ordre d'un centimètre d'épaisseur, où circule essentiellement tout le courant électronique induit dans le plasma et où se passe le transfert d'énergie entre le champ électrique induit et les électrons de la décharge par processus stochastique et collisionnel, protège le substrat contre la génération de tout courant induit à sa surface. Le rôle de cette nappe de courant induit à la périphérie du plasma, où se situe donc essentiellement tout le champ électromagnétique (EM) induit, est primordial car il permet d'obtenir un champ électromagnétique négligeable dans la zone de traitement à l'endroit qui est traversé par le substrat traité. Le plasma assure donc un blindage efficace à la propagation des ondes électromagnétiques, dont l'amplitude est atténuée très rapidement en direction de l'axe du dispositif. C'est cette caractéristique physique, qui rend possible, dans le dispositif selon l'invention, le traitement de matériaux conducteurs et, en particulier, de matériaux ferromagnétiques tels que l'acier doux.

A cet effet, il est nécessaire (1) qu'il existe un plasma préalablement au passage du substrat à travers la zone de traitement, ou (2) qu'un plasma d'allumage puisse être créé par un moyen différent de l'inducteur préalablement à la mise sous puissance radiofréquence de l'inducteur, et (3), comme déjà mentionné ci-dessus, que le substrat traité passe suffisamment loin de la zone périphérique du plasma où circule essentiellement tout le courant électronique induit dans le plasma. En pratique, n'importe quel point de la surface du substrat ne s'approchera pas à moins de 5 cm de la surface de l'électrode formant l'écran de Faraday orientée vers le plasma. Le champ électromagnétique induit décroît exponentiellement en fonction de la distance mesurée perpendiculairement par rapport à la surface du plasma en s'éloignant de l'inducteur. A 5 cm de distance, l'atténuation de l'amplitude du signal est généralement de l'ordre de 99% de sa valeur initiale.

Par conséquent, le plasma est généré par induction radiofréquence au voisinage de la surface de l'inducteur avant que le ou les substrat(s) à traiter ne défile(nt) au droit de cet inducteur, ou un dispositif quelconque permettant de générer un plasma d'allumage est prévu pour créer un plasma avant que la puissance radiofréquence ne soit couplée à l'inducteur lorsque le substrat est déjà au moins partiellement présent au droit de l'inducteur.

Un dispositif d'allumage capacitif du plasma, au cas où l'alimentation radiofréquence viendrait à être coupée en cours de traitement d'un substrat, est particulièrement bien adapté à l'application. On peut avantageusement mettre à profit la haute tension générée au connecteur susmentionné 5 ou 6 de l'inducteur au moment de la mise sous tension de celui-ci, en faisant usage d'une électrode d'allumage située dans la zone de traitement au voisinage de l'électrode formant l'écran de Faraday. Cette électrode d'allumage est connectée au connecteur susmentionné 5 ou 6 pour permettre la création d'un plasma capacitif d'allumage entre cette électrode d'allumage et le substrat, par exemple.

### 2.5. Utilisation de miroirs magnétiques

Afin de réduire les pertes de plasma par diffusion ambipolaire aux ouvertures d'entrée et de sortie situées au niveau des brides 12 et 13 susmentionnées du dispositif selon l'invention, on peut faire usage de miroirs magnétiques constitués de solénoïdes parcourus par un courant électrique qui est, de préférence, un courant continu. Ces deux solénoïdes sont avantageusement situés de manière à entourer les brides 12 et 13. Un moyen simple consiste à disposer autour du blindage 18, deux solénoïdes situés au droit des brides 12 et 13. Ces solénoïdes sont alimentés en courant par un générateur électrique indépendant permettant de créer un champ d'induction magnétique maximal au droit de chaque solénoïde.

### 3. Exemple d'applications pratiques

### 3.1. Dispositif de nettoyage pour produits longs en acier de moyenne section

Le dispositif utilisé est du type de celui représenté aux figures 1 à 3. Le produit traité présente une surface spécifique totale nominale de 2 m²/m. Les dimensions principales intérieures de l'électrode formant l'écran de Faraday 7 sont de 1 m x 0,3 m, pour une longueur axiale utile de 0,55 m. L'électrode formant l'écran de Faraday 7 est refroidie à l'eau. Le solénoïde inducteur 4 est en cuivre et refroidi à l'eau, et sa surface interne est située à 2 cm de la surface externe du plasma induit.

Le dispositif est fixé dans une chambre à vide entre deux bancs de rouleaux permettant le transport des produits 3 dans la zone de traitement 2. Le blindage 18 est maintenu à la masse. La chambre à vide est alimentée en argon à une pression de 5 10⁻³ mbar et à une température de 300K.

Dans ces conditions, un dispositif d'allumage capacitif comprenant une électrode connectée au connecteur 6 de l'inducteur 4 est utilisé. On fait usage du produit 3 maintenu à la masse comme contre électrode. Après allumage capacitif du plasma, le plasma est maintenu par induction via le solénoïde inducteur 4 en y dissipant une puissance électrique utile de 15kW à 13,56 MHz.

L'électrode formant l'écran de Faraday 7 est connectée à un générateur en courant continu qui maintient une puissance de 57 kW entre cette dernière et le produit, assurant le nettoyage de la surface du produit par bombardement d'ions sous une tension de 600 V. L'inverse du coefficient d'atténuation du champ électromagnétique en périphérie du plasma vaut 1,14cm. Par périphérie du plasma, l'on entend l'épaisseur de la peau du plasma où circule essentiellement le courant induit.

Lorsque l'inducteur du dispositif est excité, non plus à 13,56 MHz, mais à 3,39 MHz, toutes autres conditions étant égales par ailleurs, les caractéristiques du plasma sont inchangées, mais l'impédance du circuit d'excitation, entre les connecteurs 5 et 6 de l'inducteur 4 est plus basse.

### 3.2. Dispositif de nettoyage pour produits longs en acier de forte section

Le dispositif utilisé est du type de celui représenté à la figure 4 et est muni d'un blindage 18 et d'un matériau diélectrique intercalaire 17 non représentés sur cette figure. Le produit traité présente une surface spécifique totale nominale de 3 m²/m. Les dimensions principales intérieures de l'électrode formant l'écran de Faraday 7 sont de 0,8 m x 0,9 m pour une longueur axiale utile de 0,5 m.

L'électrode formant l'écran de Faraday 7 est refroidie à l'eau. Le solénoïde inducteur 4 est en cuivre et refroidi à l'eau et sa surface interne est située à 2 cm de la surface externe du plasma induit. Le dispositif est fixé dans une chambre à vide entre deux bancs de rouleaux permettant le transport du produit 3 dans la zone de traitement. Le blindage 18 est maintenu à la masse. La chambre à vide est alimentée en argon à une pression de 5 10⁻³ mbar et à une température de 300 K.

Dans ces conditions, un dispositif d'allumage capacitif constitué d'une électrode connectée au connecteur 6 et faisant usage du produit 3 maintenu à la masse comme contre électrode, permet l'allumage d'un plasma qui est ensuite entretenu par induction via le solénoïde inducteur 4 en y dissipant une puissance électrique utile de 15 kW à 13,56 MHz. L'électrode formant l'écran de Faraday 7 est connectée à un générateur en courant continu qui maintient une puissance de 50 kW entre cette dernière et le produit, assurant le nettoyage de la surface du produit par bombardement d'ions sous une tension de 600V. L'inverse du coefficient d'atténuation du champ électromagnétique en périphérie du plasma vaut 1,37 cm. Par périphérie du plasma, l'on entend l'épaisseur de la peau du plasma où circule essentiellement le courant induit.

### 3.3. Dispositif adapté au nettoyage de tôles d'acier au défilé

Le dispositif utilisé est du type de celui représenté aux figures 1 à 3. Le produit traité présente une surface spécifique totale nominale de 3 m²/m. Il s'agit en particulier d'une tôle de 1,5 m de largeur. Les dimensions principales intérieures de l'électrode formant l'écran de Faraday 7 sont de 1,7 m x 0,2 m pour une longueur axiale utile de 0,7 m. L'électrode formant l'écran de Faraday 7 est refroidie à l'eau. Le solénoïde inducteur 4 est en cuivre et refroidi à l'eau et sa surface interne est située à 2 cm de la surface externe du plasma induit. Le dispositif est fixé dans une chambre à vide de manière telle à ce qu'il soit traversé en son plan médian par la tôle défilant verticalement. Le blindage 18 est maintenu à la masse. La chambre à vide est alimentée en argon à une pression de 5 10⁻³ mbar et à une température de 300 K.

Dans ces conditions, un dispositif d'allumage capacitif comprenant une électrode connectée au connecteur 6 de l'inducteur 4 est utilisé. En faisant usage de la tôle maintenue à la masse comme contre électrode, l'allumage d'un plasma est obtenu qui est ensuite entretenu par induction via le solénoïde inducteur 4 en y dissipant une puissance électrique utile de 25 kW à 13,56 MHz.

L'électrode formant l'écran de Faraday 7 est connectée à un générateur en courant continu qui maintient une puissance de 148 kW entre cette dernière et le substrat, assurant le nettoyage de la surface du substrat par bombardement d'ions sous une tension de 900 V. L'inverse du coefficient d'atténuation du champ électromagnétique en périphérie du plasma, c.-à-d. l'épaisseur de peau du plasma où circule essentiellement le courant induit, vaut 1,2 cm sous ces conditions opérationnelles

### 4. Le dispositif formant une source de plasma ou une source d'ions

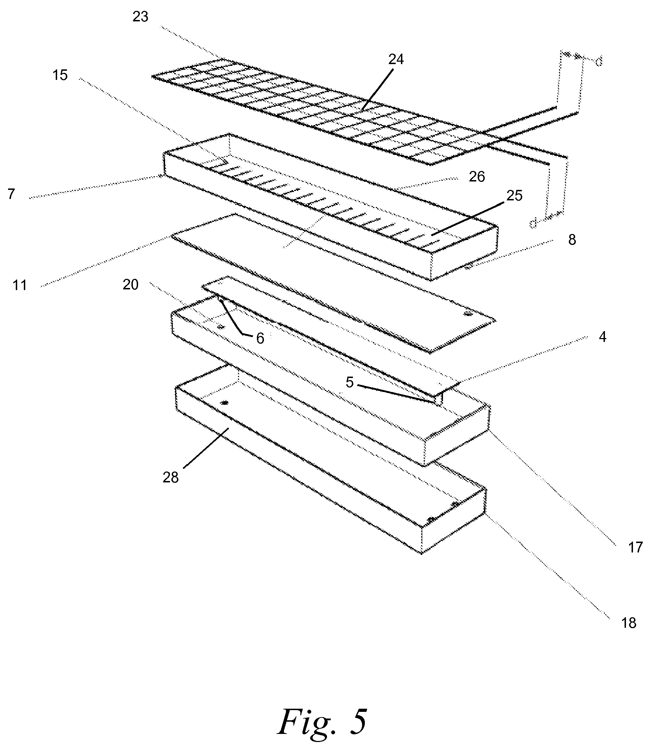

La figure 5 représente une configuration particulière du dispositif pour la mise en oeuvre d'une source plasma. Dans cette configuration, la production d'un plasma dont les ions sont accélérés à une énergie déterminée se fait sans devoir polariser un quelconque substrat. En effet, une polarisation n'est plus établie entre une électrode formant l'écran de Faraday 7 et un substrat conducteur, mais bien entre l'électrode 7 et une contre-électrode 23 en forme de grille 24. La contre-électrode 23 présente des ouvertures de dimension caractéristique « d ». La dimension caractéristique « d » des ouvertures formées dans la grille d'extraction 24 est typiquement de l'ordre de l'épaisseur de la gaine qui se forme naturellement à l'interface du plasma et de cette contre-électrode 23 maintenue à son potentiel d'extraction.

L'espacement optimal des ouvertures dans la grille 24 est de l'ordre de deux fois la valeur de l'épaisseur de gaine correspondant à la densité de plasma produite par l'inducteur et à la polarisation en moyenne positive appliquée sur l'électrode formant l'écran de Faraday 7 par rapport à cette grille 24. En effet, dans ces conditions pour la source à plasma, le plasma ne peut diffuser au travers des ouvertures par définition et les lignes de champ déterminant la trajectoire des ions qui traversent alors ces ouvertures sont prédites par les lois de l'électrostatique.

L' électrode formant l'écran de Faraday 7 présente la forme d'un bac avec un fond 25 et des parois latérales 26. Dans le fond 25 des fentes 15 sont prévues s'étendant parallèlement l'une à l'autre et sensiblement perpendiculairement à la direction de circulation du courant inducteur dans l'inducteur 4.

Le potentiel d'extraction de la grille 24 est bien entendu en moyenne négatif par rapport au potentiel de l'électrode formant l'écran de Faraday 7 qui est en moyenne positif, selon l'invention. En effet, c'est le potentiel de l'électrode formant l'écran de Faraday 7 qui est fixé par rapport à la contre-électrode 23. Le potentiel de la contre-électrode 23 peut avantageusement être celui de la masse. Dans ces conditions, les lignes de champ électrique formées à la gaine du plasma traversent essentiellement la grille 24 si la fraction ouverte de l'aire de cette grille 24 est importante par rapport à sa surface totale projetée. Ceci peut être réalisé, par exemple, en faisant usage de fils métalliques croisés de tungstène, de molybdène, d'acier, ou d'un autre matériau de plus faible diamètre que la dimension « d » des ouvertures. Typiquement, la dimension « d » est de l'ordre du millimètre en conditions normales d'utilisation, et l'on peut utiliser des fils métalliques d'une fraction de millimètre pour former la grille d'extraction 24.

Dans une autre forme de réalisation, la grille 24 peut être constituée de fils parallèles séparés les uns des autres d'une distance « d ».

En effet, lorsque le potentiel de l'électrode formant l'écran de Faraday 7 vaut en moyenne +600 V par rapport à la contre-électrode 23, pour une densité de plasma à la limite de la gaine de l'ordre de 2x10¹¹ cm⁻³ en ions d'argon, on observe typiquement une épaisseur de gaine de 1,2 mm. La grille 24 peut avantageusement être en contact électrique avec le blindage 18 qui est éventuellement connecté à la masse.

Dans ces conditions, les ions, qui suivent les lignes de champ, traversent les ouvertures de la grille d'extraction 24 avec une énergie cinétique déterminée par le potentiel de la gaine formée entre le plasma et cette grille 24, lui-même déterminé par le potentiel fixé à l'électrode formant l'écran de Faraday 7 par rapport à la contre-électrode 23. Dans l'exemple précédent, les ions sont extraits de la source avec une énergie de l'ordre de 600eV.

Afin d'éviter la formation d'une charge d'espace positive, on neutralise généralement le flux d'ions par un flux d'électrons générés par une source indépendante d'électrons. Un moyen plus élégant et moins cher consiste à faire usage d'une alimentation électrique pulsée pour polariser l'électrode formant l'écran de Faraday 7. En effet, dans ces conditions, en imposant des pulses négatifs de faible durée mais répétés sur l'électrode formant l'écran de Faraday 7, on permet aux électrons de s'échapper par les ouvertures de la grille qui est positive par impulsion par rapport à l'électrode formant l'écran de Faraday 7 et de neutraliser électriquement le flux d'ions.

Il s'agit donc bien d'une source à plasma. La durée des impulsions négatives par rapport à celle de la polarisation positive peut rester très faible. Il en est de même pour la valeur absolue du potentiel d'impulsion négatif. Il peut rester faible devant la valeur du potentiel positif, étant donné que la mobilité des électrons est largement supérieure à celle des ions.

Des fentes 15 sont réalisées dans l'électrode formant l'écran de Faraday 7. Ces fentes 15 peuvent bien entendu être protégées par des longerons 16 non représentés à la figure 5 et fixés sur les parois 26 de l'électrode 7. Ces parois 26 sont équivalents aux brides 12 et 13 représentées aux figures 1 à 4.

La géométrie de la source plasma n'est nullement limitée à la géométrie plane de la figure 5. En effet, cette géométrie peut être celle d'une structure fermée telle que représenté aux figures 1 à 4. Dans ce cas particulier de configuration géométrique, la grille d'extraction 24 doit être de géométrie semblable à celle de l'électrode formant l'écran de Faraday 7 et placée au dessus des parois 26 de manière à être électriquement isolée du potentiel de l'écran de Faraday 7.

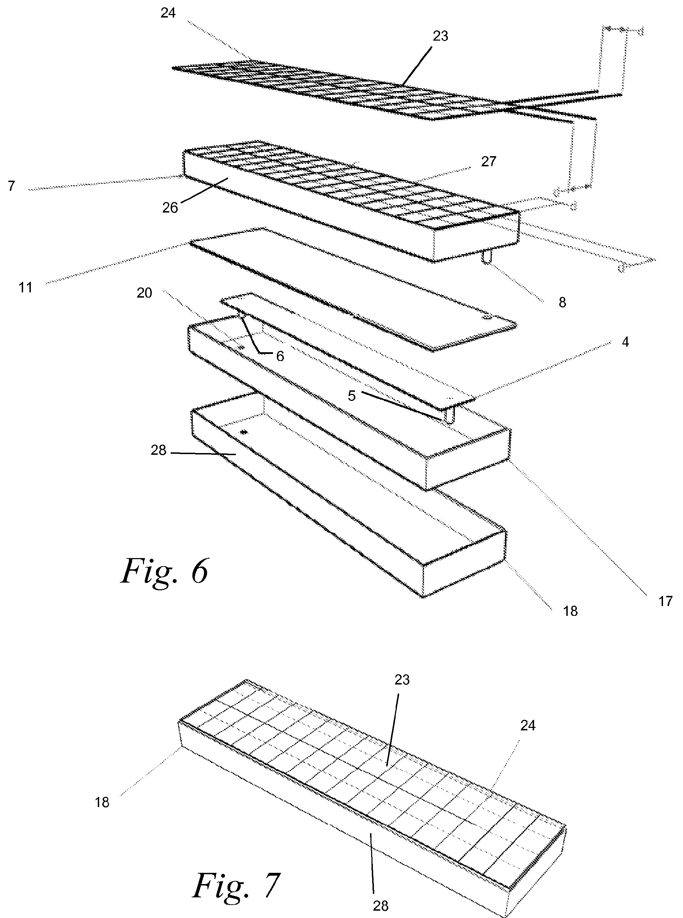

Dans la figure 6 une forme de réalisation du dispositif est représentée pour la mise en oeuvre d'une source à ions.

Dans ce cas, l'électrode formant l'écran de Faraday 7 est fermée au moyen d'une grille de sortie 27 mise au même potentiel que celui de l'électrode formant l'écran de Faraday 7. La grille d'extraction 24 formant la contre-électrode 23, qui est à un potentiel en moyenne négatif par rapport à celui de la grille de sortie 27 qui est en moyenne positif, doit être placée à une distance de l'ordre de « d » face à la grille de sortie des ions 27. Dans ces conditions, en se basant sur les méthodes bien connues des sources à ions on peut optimiser la géométrie des ouvertures des grilles pour que les lignes de champ électrique partant du plasma et traversant les deux grilles soient telles que les ions ne bombardent pas les grilles et ne les érodent pas. Les ions sont alors essentiellement accélérés dans le gap « d » séparant les grilles 27 et 24. Ceci est par exemple décrit en détail dans «The Physics and Technology of Ion Sources» par Ian G. Brown, John WILEY & Sons ISBN0471857084 (1989).

Comme mentionné dans le cas d'une source plasma ci-dessus, le flux d'ions peut être neutralisé par une source d'électrons indépendante de l'invention et non représentée sur la figure 6. Mais il est aussi particulièrement avantageux de faire usage d'une alimentation électrique pulsée pour polariser l'électrode formant l'écran de Faraday 7 de manière à ce qu'à chaque pulse négatif appliqué à cette électrode 7 et à la grille 27, des électrons puissent s'échapper du volume de plasma situé entre ces deux dernières et, après accélération entre les deux grilles 27 et 24, traverser la grille d'extraction 24 pour neutraliser le flux d'ions émis pendant la plus grande partie du cycle de polarisation de l'électrode formant l'écran de Faraday 7.

Un blindage 18 formé par un bac 28 d'une forme analogue à celle de l'électrode formant l'écran de Faraday 7 entoure cette dernière. Un matériau diélectrique 11 est présent entre l'électrode formant l'écran de Faraday 7 et l'inducteur 4. La surface intérieure du bac 28 formant le blindage 18 est revêtue avec un matériau diélectrique 17. L'électrode formant l'écran de Faraday 7 ensemble avec l'inducteur 4 est logée dans le blindage 18.

L'électrode formant l'écran de Faraday 7 est polarisée en moyenne positivement par rapport à la grille d'extraction 24. Cette dernière peut être isolée électriquement par rapport au blindage 18 mais est en général au potentiel de ce blindage 18. Le potentiel de la grille d'extraction 24 est avantageusement celui de la masse, mais pas obligatoirement.

Dans le cas d'une source à ions, le système peut aussi comporter trois électrodes : la grille de sortie 27, la grille d'extraction 24 et une électrode complémentaire située entre ces deux grilles 27 et 24, plus proche de la grille d'extraction 24 que de la grille de sortie 27, et à un potentiel légèrement plus négatif que la grille d'extraction 24 servant à empêcher le retour d'électrons vers la grille de sortie 27 lorsque ces électrons sont produits par une source indépendante du dispositif. Cette source indépendante d'électrons peut être une cathode creuse émettrice d'électrons ou un filament émetteur d'électrons. La géométrie et les positions relatives des ouvertures dans les différentes électrodes formées par les grilles sont basées sur les contours des équipotentielles dit de Pierce (cf. «The Physics and Technology of Ion Sources» par Ian G. Brown, John WILEY & Sons ISBN0471857084 (1989), p.28).

La figure 7 montre l'assemblage des parties constitutives montrées dans la représentation explosée à la figure 5 ou 6.

Il est clair que le maillage des grilles 24 et 27, ainsi que la distance « d » indiquées sur les figures 5 à 7 ne sont pas à l'échelle, pour des raisons de lisibilité du dessin.

Une injection de gaz au voisinage de l'électrode formant l'écran de Faraday 7 non représentée dans les figures est toujours nécessaire, et tout particulièrement dans le cas de sources de plasma et d'ions, car il faut compenser la perte de gaz associée au flux sortant d'ions de la source.

Les sources de plasma ou d'ions décrites ci-dessus ont l'avantage de présenter une très grande simplicité de construction et de résistance à la contamination en provenance des produits qui sont traités.

En plus, le plasma est réalisé économiquement de manière inductive et l'accélération des ions est réalisée également économiquement au moyen d'une source électrique à courant continu éventuellement pulsée. Ainsi, une source de plasma ou d'ions à haut rendement énergétique est réalisée.

Il est possible de réaliser des sources pour toutes géométries et, en particulier, planes de grandes dimensions, par exemple jusqu'à 3 m de long, par exemple pour le prétraitement du verre architectural avant revêtement dans vide.

La source à plasma peut être utilisé pour le nettoyage du verre architectural. Dans ce cas, le dispositif utilisé est une source à plasma du type de celui représenté à la figure 5 et adaptée au nettoyage de plaque de verres de 3 m de large avant revêtement par sputtering. Le dispositif est alimenté en argon et produit un plasma d'argon dont les ions sont extraits à une énergie de l'ordre de 300 eV par polarisation relative de la grille d'extraction 24 par rapport à l'électrode formant l'écran de Faraday 7 au moyen d'un alimentation DC pulsée. Le potentiel de l'électrode formant l'écran de Faraday 7 est de +300V par rapport à la masse et la grille d'extraction 24 est au potentiel du blindage 18 maintenu à la masse. La puissance consommée est de l'ordre de 15kW en courant continu pulsé pour 5 kW en radiofréquence à 13,56 MHz. L'invention est définie par les revendications.

## Revendications

1. Procédé de traitement par plasma de substrats métalliques ou isolants dans lequel l'on fait défiler au moins un substrat d'une manière sensiblement continue dans une chambre à vide présentant une zone de traitement (2) à travers cette zone de traitement (2), le plasma étant maintenu par couplage inductif radio-fréquence dans la zone de traitement (2) au moyen d'un inducteur (4) monté à l'intérieur de la chambre à vide et connecté à un générateur radio-fréquence, dans lequel l'on protège l'inducteur (4) de toute contamination par la matière émise par la surface du substrat (3) par un écran de Faraday (7) qui l'on positionne entre le plasma et l'inducteur (4) et adjacent au plasma, l'écran de Faraday (7) constituant une électrode conductrice que l'on polarise électriquement positivement en moyenne par rapport au substrat (3) ou par rapport à une contre-électrode (23) présente dans le plasma en accélérant ainsi des ions présents dans le plasma vers le substrat (3) ou vers la contre-électrode (23) et en récupérant des électrons du plasma à l'électrode formant l'écran de Faraday (7), le plasma étant généré entre l'écran de Faraday et les substrats dans la zone de traitement ou entre l'écran de Faraday et ladite contre-électrode, dans lequel la fréquence d'excitation de l'écran de Faraday (7) est inférieure d'au moins un facteur 10 par rapport à la fréquence du générateur radio-fréquence couplée à l'inducteur (4), et, en particulier inférieure à 1 MHz.

2. Procédé suivant la revendication 1, **caractérisé en ce que** l'écran de Faraday (7) est soumis à une succession de cycles de polarisation comprenant des impulsions négatives.

3. Procédé suivant la revendication 1 ou 2, **caractérisé en ce que** l'écran de Faraday (7) est polarisé positivement en moyenne par rapport au substrat (3) et que l'alimentation électrique de l'écran de Faraday (7) est connectée entre cet écran (7) et le substrat (3) et est régulée en puissance proportionnellement à l'aire du substrat (3) se déplaçant devant l'écran de Faraday (7) dans la zone de traitement (2).

4. Procédé suivant l'une quelconque des revendications 1 à 3, **caractérisé en ce qu'**une distance minimum de 2 cm, et de préférence de 5 cm, est maintenue entre l'écran de Faraday (7) et la surface du substrat (3) ou de la contre-électrode.

5. Procédé suivant l'une quelconque des revendications 1 à 4, **caractérisé en ce qu'**un plasma est généré dans la zone de traitement (2) préalablement à la mise sous puissance de l'inducteur (4) par le générateur radio-fréquence.

6. Procédé suivant l'une quelconque des revendications 1 à 5, **caractérisé en ce que** le plasma est confiné dans la zone de traitement (2) par la génération d'un champ magnétique à l'endroit où le substrat (3) entre et/ou sort la zone de traitement (2).

7. Procédé suivant l'une quelconque des revendications 1 à 6, **caractérisé en ce que** la puissance électrique appliquée entre l'écran de Faraday (7) et le substrat (3) est au moins égale à la puissance radio-fréquence servant à créer le plasma.

8. Procédé suivant l'une quelconque des revendications 1 à 7, **caractérisé en ce que** l'on permet une transmission de la puissance électromagnétique de l'inducteur (4) au plasma à travers l'écran de Faraday (7) par la présence d'une série de fentes (15) sensiblement parallèles entre-elles et sensiblement perpendiculaires à la direction de circulation du courant inducteur dans l'inducteur (4).

9. Dispositif pour le traitement de substrats métalliques ou isolants par plasma comprenant une chambre à vide avec une zone de traitement (2) dans laquelle peut défiler un substrat métallique ou isolant d'une manière sensiblement continue, le dispositif comprenant un inducteur (4) et un générateur radio-fréquence pour générer un plasma, l'inducteur étant monté à l'intérieur de la chambre à vide et connecté au générateur radio-fréquence, et un écran de Faraday (7) adjacent au plasma et qui est positionné entre le plasma et l'inducteur (4) permettant de protéger l'inducteur (4) de toute contamination par la matière émise par la surface des substrats (3), dans lequel le plasma est généré dans la zone de traitement (2) ou dans l'espace présent entre l'écran de Faraday et une contre-électrode (23), l'écran de Faraday (7) constituant une électrode conductrice le dispositif comprenant également des moyens configurés afin de polariser électriquement positivement en moyenne l'écran de Faraday (7) par rapport aux substrats (3) ou par rapport à la contre-électrode (23) et en ce que l'écran de Faraday (7) est agencé de manière à ce que le plasma est généré entre l'écran de Faraday (7) et le substrat (3) dans la zone de traitement (2) ou entre l'écran de Faraday (7) et ladite contre-électrode (23), le dispositif comprenant également un filtre passe-bas entre l'écran de Faraday (7) et l'alimentation électrique de cet écran (7) ne permettant que le passage de fréquences inférieures à 1 MHz et de préférence inférieures à 100 kHz.

10. Dispositif suivant la revendication 9, **caractérisé en ce qu'**un espace intercalaire est prévu entre l'inducteur (4) et l'écran de Faraday (7), cet espace étant comblé avec un matériau diélectrique (11).

11. Dispositif suivant la revendication 10, **caractérisé en ce que** la distance entre l'inducteur (4) et l'écran de Faraday (7) est comprise entre 0,1 et 10 cm.

12. Dispositif suivant la revendication 10 ou 11, **caractérisé en ce que** le matériau diélectrique (11) intercalaire comprend un polymère, du teflon, une mousse céramique ou de laine de verre ou d'alumine.

13. Dispositif suivant l'une quelconque des revendications 9 à 12, **caractérisé en ce que** l'écran de Faraday (7) présente une série de fentes (15) sensiblement parallèles entre-elles et sensiblement perpendiculaires à la direction de circulation du courant inducteur dans l'inducteur (4).

14. Dispositif suivant la revendication 13, **caractérisé en ce que** des longerons (16) sont positionnés à une petite distance des fentes (15) en regard de ces derniers du côté du plasma.

15. Dispositif suivant l'une quelconque des revendications 9 à 14, **caractérisé en ce qu'**un blindage (18), connecté à la masse ou maintenu à potentiel flottant, est prévu qui entoure l'inducteur (4).

16. Dispositif suivant la revendication 13, **caractérisé en ce qu'**un espace intercalaire est présent entre l'inducteur (4) et le blindage (18) qui est comblé avec un matériau diélectrique (17).

17. Dispositif suivant l'une quelconque des revendications 9 à 16, **caractérisé en ce que** l'inducteur (4) comprend au moins une spire d'induction.

18. Dispositif suivant l'une quelconque des revendications 9 à 17, **caractérisé en ce que** l'inducteur (4) est excité à une fréquence entre 1 et 170 MHz.

19. Dispositif suivant l'une quelconque des revendications 9 à 18, **caractérisé en ce que** l'alimentation de l'écran de Faraday (7) présente une fréquence d'excitation qui est au moins dix fois inférieure à la fréquence couplée à l'inducteur (4).

20. Dispositif suivant l'une quelconque des revendications 9 à 19, **caractérisé en ce que** des moyens sont prévus pour permettre la création d'un plasma d'allumage.

21. Dispositif suivant l'une quelconque des revendications 9 à 20, **caractérisé en ce que** l'inducteur (4) et l'écran de Faraday (7) présentent la forme d'un manchon enveloppant la zone de traitement (2) et dont l'axe longitudinal correspond sensiblement à la direction de défilement des substrats (3), ce manchon présentant une ouverture d'entrée et une ouverture de sortie à travers lesquelles le substrat (3) peut entrer la zone de traitement (2) et sortir de celle-ci.

22. Dispositif suivant la revendication 21, **caractérisé en ce que** ledit manchon présente une ouverture s'étendant suivant toute sa direction longitudinale.

23. Dispositif suivant l'une quelconque des revendications 9 à 22, **caractérisé en ce qu'**une contre-électrode (23) présentant des ouvertures ou des fentes avec une largeur (d) de l'ordre de l'épaisseur de la gaine formée à l'interface du plasma et cette contre-électrode (23), est prévue en regard de l'électrode formant l'écran de Faraday (7), ce dernier étant polarisé électriquement positivement en moyenne par rapport à la contre-électrode (23), de manière à constituer une source de plasma ou une source à ions.

24. Dispositif suivant la revendication 23, **caractérisé en ce qu'**une grille de sortie (27) est présente entre l'électrode formant l'écran de Faraday (7) et ladite contre-électrode, cette grille de sortie (27) étant mise au même potentiel que l'écran de Faraday (7) et étant positionnée face à la contre-électrode (23) à une distance suffisamment faible de celle-ci pour qu'aucun plasma ne puisse exister entre la grille de sortie (27) et ladite contre-électrode (23).

## Patentansprüche

1. Verfahren zur Plasmabearbeitung von metallischen oder isolierenden Substraten, wobei wenigstens ein Substrat auf im Wesentlichen kontinuierliche Weise in einer Vakuumkammer, die einen Bearbeitungsbereich (2) aufweist, durch diesen Bearbeitungsbereich (2) geführt wird, wobei das Plasma mithilfe eines Induktors (4), der im Inneren der Vakuumkammer montiert ist und mit einem Hochfrequenzgenerator verbunden ist, durch induktive Hochfrequenzkopplung im Bearbeitungsbereich (2) aufrechterhalten wird, wobei der Induktor (4) durch einen zwischen dem Plasma und dem Induktor (4) und angrenzend an das Plasma angeordneten Faraday-Schirm (7) vor jeglicher Kontamination durch Materie, die von der Oberfläche der Substrate (3) abgegeben wird, geschützt wird, wobei der Faraday-Schirm (7) eine leitende Elektrode darstellt, die in Bezug auf das Substrat (3) oder in Bezug auf eine im Plasma vorhandene Gegenelektrode (23) im Durchschnitt positiv polarisiert ist, wodurch die im Plasma vorhandenen Elektronen in Richtung auf das Substrat (3) oder die Gegenelektrode (23) beschleunigt werden, und wobei die vom Plasma ausgehenden Elektronen an der den Faraday-Schirm (7) bildenden Elektrode aufgefangen werden, wobei das Plasma zwischen dem Faraday-Schirm und den Substraten im Bearbeitungsbereich oder zwischen dem Faraday-Schirm und der Gegenelektrode gebildet wird, wobei die Anregungsfrequenz des Faraday-Schirms (7) um wenigstens einen Faktor 10 niedriger als die Frequenz des mit dem Induktor (4) gekoppelten Hochfrequenzgenerators ist und insbesondere niedriger als 1 MHz ist.

2. Verfahren nach Anspruch 1, **dadurch gekennzeichnet, dass** der Faraday-Schirm (7) einer Aufeinanderfolge von Polarisationszyklen unterworfen wird, die negative Impulse umfassen.

3. Verfahren nach Anspruch 1 oder 2, **dadurch gekennzeichnet, dass** der Faraday-Schirm (7) in Bezug auf das Substrat (3) im Durchschnitt positiv polarisiert ist und dass die Stromversorgung des Faraday-Schirms (7) zwischen diesem Schirm (7) und dem Substrat (3) angeordnet ist und ihre Leistung proportional zur Fläche des Substrats (3) geregelt ist, das sich im Bearbeitungsbereich (2) vor dem Faraday-Schirm (7) vorbeibewegt.

4. Verfahren nach einem der Ansprüche 1 bis 3, **dadurch gekennzeichnet, dass** ein Mindestabstand von 2 cm und vorzugsweise 5 cm zwischen dem Faraday-Schirm (7) und der Oberfläche des Substrats (3) oder der Gegenelektrode eingehalten wird.

5. Verfahren nach einem der Ansprüche 1 bis 4, **dadurch gekennzeichnet, dass** ein Plasma im Bearbeitungsbereich (2) erzeugt wird, bevor der Induktor (4) durch den Hochfrequenzgenerator unter Leistung gesetzt wird.

6. Verfahren nach einem der Ansprüche 1 bis 5, **dadurch gekennzeichnet, dass** das Plasma im Bearbeitungsbereich (2) eingeschlossen wird, indem an der Stelle, an der das Substrat (3) in den Bearbeitungsbereich (2) eintritt und/oder aus diesem austritt, ein Magnetfeld erzeugt wird.

7. Verfahren nach einem der Ansprüche 1 bis 6, **dadurch gekennzeichnet, dass** die zwischen dem Faraday-Schirm (7) und dem Substrat (3) angelegte elektrische Leistung wenigstens gleich der Hochfrequenzleistung ist, die dazu dient, das Plasma zu erzeugen.

8. Verfahren nach einem der Ansprüche 1 bis 7, **dadurch gekennzeichnet, dass** eine Übertragung der elektromagnetischen Leistung vom Induktor (4) durch den Faraday-Schirm (7) zum Plasma durch das Vorhandensein einer Reihe von Schlitzen (15) ermöglicht wird, die im Wesentlichen parallel zueinander und im Wesentlichen senkrecht zur Zirkulationsrichtung des induzierenden Stroms im Induktor (4) sind.

9. Vorrichtung zur Plasmabearbeitung von metallischen oder isolierenden Substraten, umfassend eine Vakuumkammer mit einem Bearbeitungsbereich (2), durch den ein metallisches oder isolierendes Substrat auf im Wesentlichen kontinuierliche Weise geführt werden kann, wobei die Vorrichtung Folgendes umfasst: einen Induktor (4) und einen Hochfrequenzgenerator zur Erzeugung eines Plasmas, wobei der Induktor im Inneren der Vakuumkammer montiert ist und mit dem Hochfrequenzgenerator verbunden ist, und einen an das Plasma angrenzenden Faraday-Schirm (7), der zwischen dem Plasma und dem Induktor (4) angeordnet ist und es ermöglicht, den Induktor (4) vor jeglicher Kontamination durch Materie, die von der Oberfläche der Substrate (3) abgegeben wird, zu schützen, wobei das Plasma im Bearbeitungsbereich (2) oder im Raum zwischen dem Faraday-Schirm und einer Gegenelektrode (23) erzeugt wird, wobei der Faraday-Schirm (7) eine leitende Elektrode darstellt und wobei die Vorrichtung auch Mittel umfasst, die dafür ausgelegt sind, den Faraday-Schirm (7) in Bezug auf die Substrate (3) oder in Bezug auf die Gegenelektrode (23) im Durchschnitt positiv zu polarisieren, und wobei der Faraday-Schirm (7) derart ausgestaltet ist, dass das Plasma im Bearbeitungsbereich (2) zwischen dem Faraday-Schirm (7) und dem Substrat (3) oder zwischen dem Faraday-Schirm (7) und der Gegenelektrode (23) erzeugt wird, wobei die Vorrichtung auch einen Tiefpassfilter zwischen dem Faraday-Schirm (7) und der Stromversorgung dieses Schirms (7) umfasst, der nur Frequenzen unter 1 MHz und vorzugsweise unter 100 kHz durchlässt.

10. Vorrichtung nach Anspruch 9, **dadurch gekennzeichnet, dass** ein Zwischenraum zwischen dem Induktor (4) und dem Faraday-Schirm (7) vorgesehen ist, wobei dieser Raum mit einem dielektrischen Material (11) gefüllt ist.

11. Vorrichtung nach Anspruch 10, **dadurch gekennzeichnet, dass** der Abstand zwischen dem Induktor (4) und dem Faraday-Schirm (7) zwischen 0,1 und 10 cm beträgt.

12. Vorrichtung nach Anspruch 10 oder 11, **dadurch gekennzeichnet, dass** das dielektrische Zwischenmaterial (11) ein Polymer, Teflon, einen Keramikschaum oder Glas- oder Aluminiumoxidwolle umfasst.

13. Vorrichtung nach einem der Ansprüche 9 bis 12, **dadurch gekennzeichnet, dass** der Faraday-Schirm (7) eine Reihe von Schlitzen (15) aufweist, die im Wesentlichen parallel zueinander und im Wesentlichen senkrecht zur Zirkulationsrichtung des induzierenden Stroms im Induktor (4) sind.

14. Vorrichtung nach Anspruch 13, **dadurch gekennzeichnet, dass** Längsträger (16) in geringer Entfernung von den Schlitzen (15) diesen gegenüberliegend an der Seite des Plasmas angeordnet sind.

15. Vorrichtung nach einem der Ansprüche 9 bis 14, **dadurch gekennzeichnet, dass** eine mit der Masse verbundene oder auf schwebendem Potential gehaltene Abschirmung (18) vorgesehen ist, die den Induktor (4) umgibt.

16. Vorrichtung nach Anspruch 13, **dadurch gekennzeichnet, dass** ein Zwischenraum zwischen dem Induktor (4) und der Abschirmung (18) vorgesehen ist, der mit einem dielektrischen Material (17) gefüllt ist.

17. Vorrichtung nach einem der Ansprüche 9 bis 16, **dadurch gekennzeichnet, dass** der Induktor (4) wenigstens eine Induktionswindung umfasst.

18. Vorrichtung nach einem der Ansprüche 9 bis 17, **dadurch gekennzeichnet, dass** der Induktor (4) mit einer Frequenz zwischen 1 und 170 MHz angeregt wird.

19. Vorrichtung nach einem der Ansprüche 9 bis 18, **dadurch gekennzeichnet, dass** die Versorgung des Faraday-Schirms (7) eine Anregungsfrequenz aufweist, die wenigstens zehn Mal kleiner ist als die mit dem Induktor (4) gekoppelte Frequenz.

20. Vorrichtung nach einem der Ansprüche 9 bis 19, **dadurch gekennzeichnet, dass** Mittel vorgesehen sind, um die Erzeugung eines Zündplasmas zu ermöglichen.

21. Vorrichtung nach einem der Ansprüche 9 bis 20, **dadurch gekennzeichnet, dass** der Induktor (4) und der Faraday-Schirm (7) die Form einer Manschette aufweisen, die den Bearbeitungsbereich (2) umgibt und deren Längsachse im Wesentlichen der Durchlaufrichtung der Substrate (3) entspricht, wobei diese Manschette eine Einlassöffnung und eine Auslassöffnung aufweist, durch die das Substrat (3) in den Bearbeitungsbereich (2) eintreten und aus diesem austreten kann.

22. Vorrichtung nach Anspruch 21, **dadurch gekennzeichnet, dass** die Manschette eine Öffnung aufweist, die sich über ihre gesamte Längsrichtung erstreckt.

23. Vorrichtung nach einem der Ansprüche 9 bis 22, **dadurch gekennzeichnet, dass** eine Gegenelektrode (23), die Öffnungen oder Schlitze mit einer Breite (d) in der Größenordnung der Dicke der an der Grenzfläche zwischen dem Plasma und dieser Gegenelektrode (23) gebildeten Umhüllung aufweist, gegenüber der Elektrode vorgesehen ist, die den Faraday-Schirm (7) bildet, wobei dieser in Bezug auf die Gegenelektrode (23) im Durchschnitt positiv polarisiert ist, um eine Plasmaquelle oder eine Ionenquelle zu bilden.

24. Vorrichtung nach Anspruch 23, **dadurch gekennzeichnet, dass** ein Auslassgitter (27) zwischen der den Faraday-Schirm (7) bildenden Elektrode und der Gegenelektrode vorgesehen ist, wobei dieses Auslassgitter (27) auf das gleiche Potential wie der Faraday-Schirm (7) gebracht wird und gegenüber der Gegenelektrode (23) in einer Entfernung von dieser angeordnet wird, die gering genug ist, dass kein Plasma zwischen dem Auslassgitter (27) und der Gegenelektrode (23) vorhanden sein kann.

## Claims

1. Method for the plasma treatment of metal or insulating substrates in which at least one substrate is made to pass substantially continuously through a vacuum chamber having a treatment area (2) through this treatment area (2), the plasma being maintained by radio-frequency inductive coupling in the treatment area (2) by means of an inductor (4) mounted inside the vacuum chamber and connected to a radio-frequency generator, in which the inductor (4) is protected from any contamination by the material emitted by the surface of the substrate (3) by a Faraday screen (7) that is positioned between the plasma and the inductor (4) and adjacent to the plasma, the Faraday screen (7) constituting a conductive electrode which is electrically polarised on average positively with respect to the substrate (3) or with respect to a counter-electrode (23) present in the plasma, thus accelerating ions present in the plasma towards the substrate (3) or towards the counter-electrode (23) and recovering electrons from the plasma at the electrode forming the Faraday screen (7), the plasma being generated between the Faraday screen and the substrates in the treatment area or between the Faraday screen and the said counter-electrode, wherein the excitation frequency of the Faraday screen (7) is lower by at least a factor of 10 with respect to the frequency of the radio-frequency generator coupled to the inductor (4) and in particular less than 1 MHz.

2. Method according to claim 1, **characterised in that** the Faraday screen (7) is subjected to a succession of polarising cycles comprising negative pulses.

3. Method according to claim 1 or2, **characterised in that** the Faraday screen (7) is polarised on average positively with respect to the substrate (3) and **in that** the electrical supply to the Faraday screen (7) is connected between this screen (7) and the substrate (3) and is regulated for power proportionally to the area of the substrate (3) moving in front of the Faraday screen (7) in the treatment area (2).

4. Method according to any one of claims 1 to 3, **characterised in that** a minimum distance of 2 cm, and preferably 5 cm, is maintained between the Faraday screen (7) and the surface of the substrate (3) or of the counter-electrode.

5. Method according to any one of claims 1 to 4, **characterised in that** a plasma is generated in the treatment area (2) prior to the inductor (4) being powered up by the radio-frequency generator.

6. Method according to any one of claims 1 to 5, **characterised in that** the plasma is confined in the treatment area (2) by the generation of a magnetic field at the point where the substrate (3) enters and/or leaves the treatment area (2).

7. Method according to any one of claims 1 to 6, **characterised in that** the electrical power applied between the Faraday screen (7) and the substrate (3) is at least equal to the radio-frequency power serving to create the plasma.

8. Method according to any one of claims 1 to 7, **characterised in that** transmission of the electromagnetic power of the inductor (4) to the plasma through the Faraday screen (7) is allowed by the presence of a series of slots (15) substantially parallel to one another and substantially perpendicular to the direction of flow of the inducing current in the inductor (4).

9. Device for the treatment of metal or insulating substrates by plasma, comprising a vacuum chamber with a treatment area (2) in which a metal or insulating substrate can pass substantially continuously, the device comprising an inductor (4) and a radio-frequency generator in order to generate a plasma, the inductor being mounted inside the vacuum chamber and connected to the radio-frequency generator, and a Faraday screen (7) adjacent to the plasma and positioned between the plasma and the inductor (4) for protecting the inductor (4) from any contamination by the material emitted by the surface of the substrates (3), in which the plasma is generated in the treatment area (2) or in the space present between the Faraday screen and a counter-electrode (23), the Faraday screen (7) constituting a conductive electrode, the device further comprising means configured for electrically polarising the Faraday screen (7) on average positively with respect to the substrates (3) or with respect to the counter-electrode (23), and in that the Faraday screen (7) is arranged so that the plasma is generated between the Faraday screen (7) and the substrate (3) in the treatment area (2) or between the Faraday screen (7) and said counter-electrode (23), the device further comprising a low-pass filter between the Faraday screen (7) and the electrical supply to this screen (7) allowing only the passage of frequencies below 1 MHz and preferably below 100 kHz.

10. Device according to claim 9, **characterised in that** an intermediate space is provided between the inductor (4) and the Faraday screen (7), this space being filled in with a dielectric material (11).

11. Device according to claim 10, **characterised in that** the distance between the inductor (4) and the Faraday screen (7) is between 0.1 and 10 cm.

12. Device according to claim 10 or 11, **characterised in that** the intermediate dielectric material (11) comprises a polymer, Teflon, a ceramic foam or glass or alumina wool.

13. Device according to any one of claims 9 to 12, **characterised in that** the Faraday screen (7) has a series of slots (15) substantially parallel to one another and substantially perpendicular to the direction of flow of the inducing current in the inductor (4).

14. Device according to claim 13, **characterised in that** longitudinal members (16) are positioned at a short distance from the slots (15) opposite the latter on the plasma side.

15. Device according to any one of claims 9 to 14, **characterised in that** a shielding (18), connected to earth or maintained at a floating potential, is provided which surrounds the inductor (4).

16. Device according to claim 13, **characterised in that** an intermediate space is present between the inductor (4) and the shielding (18) that is filled in with a dielectric material (17).

17. Device according to any one of claims 9 to 16, **characterised in that** the inductor (4) comprises at least one induction turn.

18. Device according to any one of claims 9 to 17, **characterised in that** the inductor (4) is excited at a frequency of between 1 and 170 MHz.

19. Device according to any one of claims 9 to 18, **characterised in that** the supply to the Faraday screen (7) has an excitation frequency that is no more than one tenth of the frequency coupled to the inductor (4).

20. Device according to any one of claims 9 to 19, **characterised in that** means are provided for enabling an ignition plasma to be created.

21. Device according to any one of claims 9 to 20, **characterised in that** the inductor (4) and the Faraday screen (7) are in the form of a sleeve enveloping the treatment area (2) and the longitudinal axis of which corresponds substantially to the direction of travel of the substrates (3), this sleeve having an entry opening and an exit opening through which the substrate (3) can enter the treatment area (2) and leave it.

22. Device according to claim 21, **characterised in that** said sleeve has an opening extending all along its longitudinal direction.

23. Device according to any one of claims 9 to 22, **characterised in that** a counter-electrode (23) having openings or slots with a width (d) of around the thickness of the sheath formed by the interface of the plasma and this counter-electrode (23), is provided opposite the electrode forming the Faraday screen (7), the latter being electrically polarised on average positively with respect to the counter-electrode (23), so as to constitute a plasma source or an ion source.

24. Device according to claim 23, **characterised in that** an exit grille (27) is present between the electrode forming the Faraday screen (7) and said counter electrode, this exit grille (27) being put at the same potential as the Faraday screen (7) and being positioned facing the counter-electrode (23) at a sufficiently short distance therefrom so that no plasma can exist between the exit grille (27) and said counter-electrode (23).
